(19) Europäisches Patentamt

European Patent Office

Office européen des brevets

(11) **EP 2 590 289 B1**

(12) **FASCICULE DE BREVET EUROPEEN**

(45) Date de publication et mention
de la délivrance du brevet:
**30.07.2014 Bulletin 2014/31**

(51) Int Cl.:
*H02J 3/00* (2006.01)     *H02J 13/00* (2006.01)

(21) Numéro de dépôt: **11306435.6**

(22) Date de dépôt: **04.11.2011**

(54) **Procédé et dispositif de surveillance d'une ligne de transmission de courant électrique à haute tension**

Verfahren und Vorrichtung zur Überwachung einer Hochspannungsstromleitung

Method and device for monitoring a high-voltage electric-current transmission line

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(43) Date de publication de la demande:
**08.05.2013 Bulletin 2013/19**

(73) Titulaire: **RTE Réseau de Transport d'Electricité
92919 Paris La Défense Cedex (FR)**

(72) Inventeur: **Stevenin, Pierre
75015 Paris (FR)**

(74) Mandataire: **Bonnet, Michel
Cabinet Bonnet
93, Rue Réaumur - Boîte 10
75002 Paris (FR)**

(56) Documents cités:
**US-A- 5 140 257      US-A- 5 559 430
US-A1- 2008 189 061    US-A1- 2010 017 153**

• **W. BLACK ET AL: "Real-Time Ampacity Model for
Overhead Lines", IEEE TRANSACTIONS ON
POWER APPARATUS AND SYSTEMS, vol. PAS-
102, no. 7, 1 juillet 1983 (1983-07-01), pages
2289-2293, XP55027255, ISSN: 0018-9510, DOI:
10.1109/TPAS.1983.318152**

**EP 2 590 289 B1**

**Description**

La présente invention concerne un procédé de surveillance d'une ligne de transmission de courant électrique à haute tension. Elle concerne également un dispositif pour la mise en oeuvre de ce procédé et un programme d'ordinateur correspondant.

L'invention s'applique plus particulièrement à un procédé de surveillance comportant :

- la détermination préalable d'une ampacité de la ligne à haute tension à partir d'une température limite de fonctionnement de la ligne à haute tension, dite température de répartition, de paramètres de conduction de la ligne à haute tension et de paramètres météorologiques,
- la mesure d'une intensité effectivement transmise par la ligne à haute tension à l'aide d'au moins un capteur disposé sur la ligne à haute tension, et
- la surveillance, par un dispositif de surveillance relié au capteur, d'un dépassement de l'ampacité par l'intensité mesurée.

L'ampacité d'une ligne à haute tension est la valeur limite admissible de l'intensité du courant porté par cette ligne, exprimée en ampères. Il est généralement posé comme postulat que cette ampacité est une constante dont la valeur est dépendante de la température de répartition, elle-même constante et calculée sur la base de paramètres géométriques supposés constants de la ligne à haute tension, et de paramètres météorologiques. La relation entre l'ampacité et la température de répartition est alors exprimée selon une équation fournissant de façon déterministe une valeur d'intensité en fonction d'une valeur de température du conducteur de la ligne à haute tension, de paramètres météorologiques et de données intrinsèques du conducteur. Les paramètres météorologiques sont choisis a priori comme les plus défavorables possibles dans l'environnement de la ligne à haute tension pour s'assurer que l'ampacité résultante calculée de cette façon constitue une valeur limite réellement pertinente vis-à-vis des risques de dépassement de la température de répartition. En conséquence, l'ampacité calculée est généralement sous-optimale. Les paramètres météorologiques étant choisis a priori, les risques réels de dépassement de la température de répartition, bien que limités, ne sont généralement pas maîtrisés.

Dans la demande de brevet internationale publiée sous le numéro WO 2010/054072, ce problème est soulevé et contourné par le calcul d'une ampacité instantanée dynamique sur la base de paramètres météorologiques instantanés issus de capteurs et fournis régulièrement. Bien sûr, cette ampacité instantanée donne une bien meilleure estimation de l'intensité limite de fonctionnement, mais elle nécessite des moyens de traitement en temps réel présentant une certaine complexité et surtout l'ajout de capteurs convenant pour relever des paramètres météorologiques pertinents. Elle n'est donc pas optimale économiquement. En outre, elle reste basée sur une relation simplifiée entre la température du conducteur et l'intensité résultante.

Par ailleurs, une ampacité statique définie par défaut reste malgré tout nécessaire.

Le document US 2010/0017153 A1 divulgue un procédé de surveillance d'une ligne de transmission de courant électrique à haute tension comportant :

- la mesure d'une température de la ligne à l'aide d'un capteur de température,
- la détermination et la prédiction d'une variation de charge électrique au cours du temps à l'aide de la mesure de température et de paramètres de charge pondérés,
- la détermination et la prédiction d'une variation de température de ligne au cours du temps à partir de la variation estimée de la charge électrique, et
- l'estimation d'une capacité de charge limite correspondant à une température limite de fonctionnement, cette estimation prenant en compte des paramètres météorologiques caractérisant l'environnement de la ligne, des paramètres techniques de la ligne et les prédictions précédentes.

Il peut ainsi être souhaité de prévoir un procédé de surveillance d'une ligne de transmission de courant électrique à haute tension qui permette de s'affranchir d'au moins une partie des problèmes et contraintes précités, notamment qui permette d'effectuer un calcul plus précis et fiable d'une valeur d'ampacité statique.

Il est donc proposé un procédé de surveillance d'une ligne de transmission de courant électrique à haute tension comportant :

- la détermination préalable d'une ampacité de la ligne à haute tension à partir d'une température limite de fonctionnement de la ligne à haute tension, dite température de répartition, de paramètres de conduction de la ligne à haute tension et de paramètres météorologiques,
- la mesure d'une intensité effectivement transmise par la ligne à haute tension à l'aide d'au moins un capteur disposé sur la ligne à haute tension, et

- la surveillance, par un dispositif de surveillance relié au capteur, d'un dépassement de l'ampacité par l'intensité mesurée,

caractérisé en ce que la détermination préalable de l'ampacité comporte :

- la sélection d'une valeur de cette ampacité par optimisation d'une probabilité de dépassement de la température de répartition, cette probabilité étant définie sur la base d'un modèle de probabilité jointe de température et d'intensité de fonctionnement dépendant des paramètres météorologiques, et
- l'enregistrement de la valeur d'ampacité sélectionnée dans des moyens de stockage du dispositif de surveillance.

Ainsi, en intégrant un modèle probabiliste de dépassement de la température de répartition dans le calcul de l'ampacité, on obtient une valeur de cette dernière qui prend directement en compte un facteur de risque. Il suffit simplement que le modèle soit construit sur la base de données réalistes, par exemple des données réelles et nombreuses d'échantillonnage, pour fournir un résultat fiable. Par ailleurs, les données pouvant être géolocalisées, la valeur finale obtenue pour l'ampacité de la ligne à haute tension considérée peut être elle-même également pertinente géographiquement.

De façon optionnelle, la sélection d'une valeur d'ampacité comporte :

- l'initialisation de l'ampacité à une première valeur,
- la boucle d'étapes suivantes, exécutée au moins une fois :

  - l'estimation de la probabilité de dépassement de la température de répartition pour la valeur d'ampacité donnée,
  - la comparaison de cette probabilité avec une valeur limite, et
  - la mise à jour de la valeur d'ampacité en fonction de cette comparaison.

De façon optionnelle également, la mise à jour de la valeur d'ampacité consiste à augmenter cette valeur si la probabilité estimée est inférieure à la valeur limite et à la réduire si la probabilité estimée est supérieure à la valeur limite.

De façon optionnelle également, la boucle d'étapes comporte un critère d'arrêt, notamment un nombre maximal de répétitions de la boucle d'étapes ou une différence entre la probabilité estimée et la valeur limite inférieure à un seuil prédéterminé lorsque cette probabilité estimée est inférieure à la valeur limite.

De façon optionnelle également, la mise à jour de la valeur d'ampacité comporte l'application d'une convergence par dichotomie.

De façon optionnelle également, le modèle de probabilité jointe de température et d'intensité de fonctionnement est défini comme le produit, intégré sur une pluralité d'intensités comprises entre 0 et l'ampacité, d'une probabilité, dépendante des paramètres météorologiques, que la température de fonctionnement soit supérieure à la température de répartition pour une intensité donnée avec une probabilité que cette intensité soit atteinte compte tenu de l'ampacité.

De façon optionnelle également, la probabilité, dépendante des paramètres météorologiques, que la température de fonctionnement soit supérieure à la température de répartition pour une intensité donnée est calculée sur la base d'un modèle établi par échantillonnage stochastique à partir d'échantillons de variables aléatoires météorologiques et d'une fonction de transfert prédéterminée, reliant les paramètres météorologiques et des paramètres de conduction de la ligne à haute tension à une température de fonctionnement de la ligne à haute tension.

De façon optionnelle également, en régime transitoire de déséquilibre thermique entre les puissances d'échauffement et de refroidissement d'un conducteur aérien de la ligne à haute tension, la probabilité de dépassement de la température de répartition est plus précisément définie sur la base du modèle de probabilité jointe de température et d'intensité de fonctionnement corrigé au moins par les deux facteurs multiplicatifs suivants :

- un facteur quantifiant une probabilité d'apparition d'un défaut dans la ligne à haute tension, et
- un facteur quantifiant une probabilité de durée de surcharge maximale de la ligne à haute tension.

L'invention a également pour objet un programme d'ordinateur téléchargeable depuis un réseau de communication et/ou enregistré sur un support lisible par ordinateur et/ou exécutable par un processeur, caractérisé en ce qu'il comprend des instructions pour l'exécution des étapes d'un procédé de surveillance d'une ligne de transmission de courant électrique à haute tension tel que défini précédemment, lorsque ledit programme est exécuté sur un ordinateur.

L'invention a également pour objet un dispositif de surveillance d'une ligne de transmission de courant électrique à haute tension comportant :

- un calculateur conçu pour la détermination préalable d'une ampacité de la ligne à haute tension à partir d'une température limite de fonctionnement de la ligne à haute tension, dite température de répartition, de paramètres de conduction de la ligne à haute tension et de paramètres météorologiques,
- des moyens de stockage de la valeur d'ampacité déterminée,
- une interface de transmission de données conçue pour la réception de données de mesure d'une intensité effectivement transmise par la ligne à haute tension issues d'au moins un capteur disposé sur la ligne à haute tension, et
- un détecteur de dépassement de l'ampacité par l'intensité mesurée,

caractérisé en ce que :

- les moyens de stockage comportent des paramètres d'un modèle de probabilité jointe de température et d'intensité de fonctionnement dépendant des paramètres météorologiques, et
- le calculateur est plus précisément conçu pour déterminer l'ampacité de la ligne à haute tension par la sélection d'une valeur de cette ampacité par optimisation d'une probabilité de dépassement de la température de répartition, cette probabilité étant définie sur la base du modèle de probabilité stocké.

L'invention sera mieux comprise à l'aide de la description qui va suivre, donnée uniquement à titre d'exemple et faite en se référant aux dessins annexés dans lesquels :

- la figure 1 représente schématiquement la structure générale d'une installation comportant une ligne à haute tension et un dispositif de surveillance selon un mode de réalisation de l'invention,
- les figures 2 et 3 représentent schématiquement deux modes de réalisation différents du dispositif de surveillance de la figure 1,
- la figure 4 illustre les étapes successives d'un procédé de surveillance mis en oeuvre le dispositif de surveillance de la figure 2 ou 3, selon un mode de réalisation de l'invention
- les figures 5 et 6 sont des diagrammes illustratifs de modèles de lois de probabilités dont les paramètres sont stockés par le dispositif de surveillance de la figure 2 ou 3, et
- la figure 7 illustre une étape de calcul du procédé de la figure 4 utilisant les modèles des figures 5 et 6.

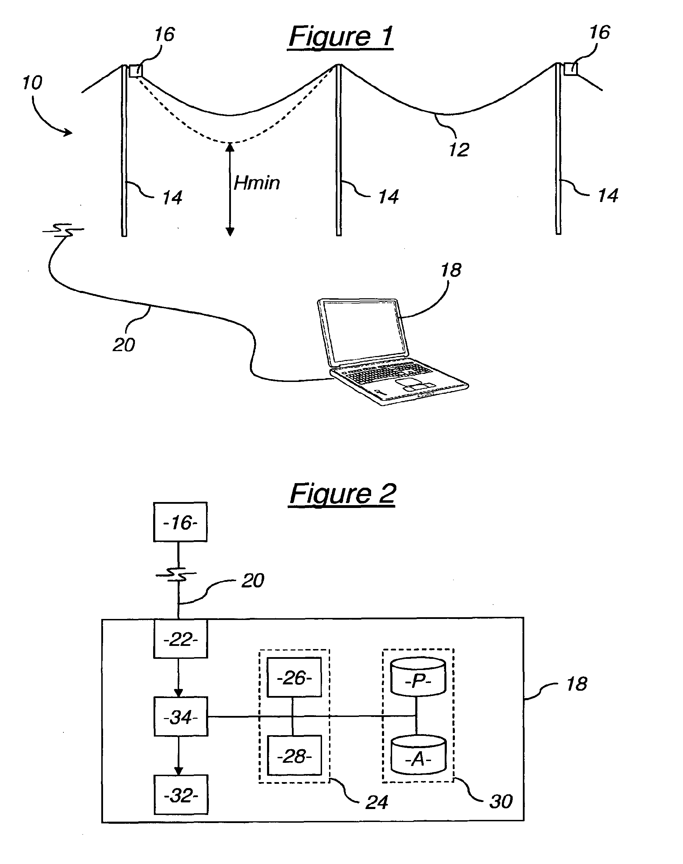

L'installation illustrée sur la figure 1 comporte une ligne 10 de transmission de courant électrique à haute tension comprenant au moins un conducteur aérien 12 fixé, à intervalles réguliers, à des pylônes 14. Cette installation est destinée à opérer soit en régime établi, lors duquel on observe un équilibre thermique entre les puissances d'échauffement et de refroidissement du conducteur aérien, soit en régime transitoire, lors duquel les puissances d'échauffement et de refroidissement du conducteur aérien sont en déséquilibre thermique. Les pylônes 14 sont destinés à maintenir le conducteur aérien 12 au-delà d'une certaine hauteur minimale Hmin en régime établi ou H'min en régime transitoire.
L'installation de la figure 1 comporte également au moins un capteur 16 disposé le long du conducteur aérien 12 et conçu pour mesurer à chaque instant une intensité effectivement transmise par la ligne à haute tension 10.
La hauteur Hmin à respecter entre le conducteur aérien 12 et le sol (ou une installation quelconque disposée sous le conducteur aérien) lorsqu'il est sous tension en régime établi dans un ouvrage de tension nominale U est généralement calculée en tant que somme d'une distance b minimale, dite « distance de base », et d'une distance t dépendante de U, dite « distance de tension ». La distance de base b est déterminée par des considérations d'encombrement à partir de l'affectation du sol et de la nature des installations qu'il comporte. Elle est fonction aussi du risque à prendre en compte, qui découle du niveau de tension et de l'isolation éventuelle des conducteurs. La distance de tension t est quant à elle fonction de la tension nominale U des ouvrages et de la probabilité que, dans un laps de temps donné, une personne ou un objet soit situé à la distance de base b du sol ou de l'installation considérée. Il convient ainsi d'adopter pour la distance t l'une des trois évaluations t1, t2, ou t3 suivantes selon que la probabilité de voisinage est considérée comme faible, moyenne ou forte :

- t1 = 0,0025 U,
- t2 = 0,005 U, et
- t3 = 0,0075 U,

où t1, t2, t3 sont exprimés en mètres et U en kilovolts. La valeur de t est obtenue en arrondissant t1, t2 ou t3 (selon le cas) au décimètre le plus proche. Concrètement, la distance de tension permet de se prémunir des phénomènes de surtension dans le conducteur aérien 12.
Par conséquent, pour qu'un amorçage ait lieu en régime établi (i.e. la formation d'un arc électrique à partir de la ligne à haute tension considérée), il faut que les trois conditions suivantes soient réalisées :

- la hauteur Hmin n'est pas respectée,
- une surtension apparaît dans la ligne à haute tension, et

- un élément tiers se trouve à l'aplomb de la ligne à haute tension.

A la hauteur Hmin correspond une température maximale du conducteur aérien 12 ou température limite de fonctionnement de la ligne à haute tension 10, dite « température de répartition ». La valeur Trep de cette température de répartition peut être calculée de façon déterministe et connue en soi à partir de la hauteur Hmin et de paramètres géométriques locaux de la ligne à haute tension tels que : hauteur de fixation du conducteur aérien entre deux pylônes et distance entre ces pylônes, hauteur H entre le point le plus bas du conducteur aérien et le sol à une température de référence donnée, etc.

Un raisonnement similaire s'applique au régime transitoire, si ce n'est que la hauteur H'min à respecter entre le conducteur aérien 12 et le sol (ou une installation quelconque disposée sous le conducteur aérien) est calculée en tant que somme de la distance de base b et d'une distance de tension t' qui ne prend pas en compte les surtensions. La distance de tension t' est inférieure à t, de sorte que la hauteur H'min est inférieure à Hmin et que la température de répartition T'rep en régime transitoire est supérieure à Trep. En revanche la température de répartition Trep en régime établi est tolérée en permanence, alors que la température de répartition T'rep en régime transitoire n'est tolérée que pendant une durée prédéterminée de 10, 20 ou 30 mn par exemple.

L'installation illustrée sur la figure 1 comporte en outre un dispositif de surveillance 18 relié au capteur 16, conçu pour :

- déterminer préalablement une valeur de l'ampacité de la ligne à haute tension 10 à partir de la température de répartition, de paramètres de conduction de la ligne à haute tension 10 et de paramètres météorologiques tels que des valeurs de température ambiante, d'ensoleillement et de vitesse du vent,
- stocker cette valeur d'ampacité,
- recevoir des données de mesure de l'intensité effectivement transmise par la ligne à haute tension 10 issues du capteur 16, et
- détecter le dépassement de l'ampacité par l'intensité mesurée, ce dépassement pouvant être à l'origine du déclenchement d'une alarme ou de l'arrêt d'une transmission de courant sur la ligne à haute tension 10.

L'ampacité étant fonction de la température de répartition, sa valeur sera également fonction du régime établi ou transitoire. En régime établi, elle est généralement qualifiée d'intensité « de secours temporaire » et en régime transitoire, d'intensité « transitoire ».

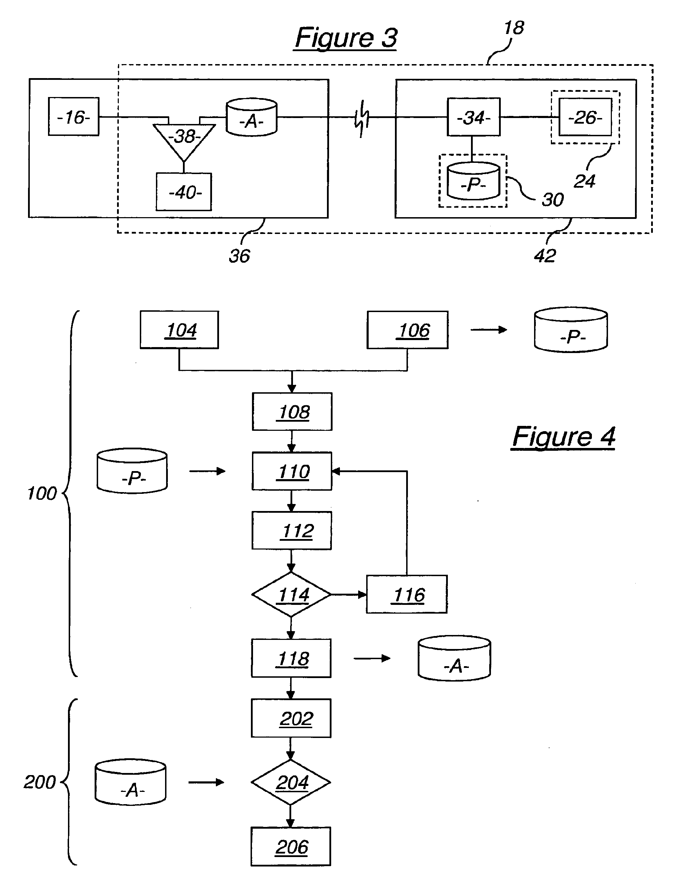

Différents modes de réalisation peuvent être imaginés pour la mise en oeuvre du dispositif de surveillance 18, dont deux vont être détaillés en référence aux figures 2 et 3. Sur la figure 1, ce dispositif est représenté comme pouvant être matérialisé par un ordinateur. De façon classique, cet ordinateur comporte un microprocesseur, une mémoire vive pour l'exécution de traitements commandés par le microprocesseur, une mémoire non volatile pour le stockage de paramètres et de programmes d'ordinateurs, un bus pour l'échange de données entre le microprocesseur, la mémoire vive et la mémoire non volatile, au moins un port de communication pour l'échange de données avec des dispositifs externes tels que le capteur 16, etc. Plus précisément, la mémoire non volatile peut stocker un programme d'ordinateur conçu pour la détermination préalable de l'ampacité et un programme d'ordinateur conçu pour la détection d'un dépassement de l'ampacité par l'intensité mesurée et le déclenchement éventuel d'une alarme.

Un lien filaire 20 est illustré pour raccorder le dispositif de surveillance 18 au capteur 16 mais ce lien peut également être au moins partiellement hertzien.

Dans le premier mode de réalisation illustré sur la figure 2, par exemple conforme à l'illustration de la figure 1, le dispositif de surveillance 18 est un appareil électronique programmable, par exemple un ordinateur ou un circuit intégré programmable, en communication avec le capteur 16 via le lien filaire ou hertzien 20, comportant :

- un port 22 d'échange de données avec le capteur 16, fonctionnant selon un protocole de communication compatible avec le lien 20, pour la réception de données de mesure d'une intensité effectivement transmise par la ligne à haute tension 10,
- des premiers moyens de stockage 24, par exemple une partie d'une mémoire non volatile, comportant un premier programme d'ordinateur 26 conçu pour une détermination préalable de l'ampacité de la ligne à haute tension 10 et un second programme 28 conçu pour une détection d'un dépassement de l'ampacité par l'intensité mesurée,
- des seconds moyens de stockage 30, par exemple une partie d'une mémoire non volatile, comportant des paramètres P (ou P' en régime transitoire) d'un modèle de probabilité jointe de température et d'intensité de fonctionnement de la ligne à haute tension 10 dépendant de paramètres météorologiques et une valeur de l'ampacité A (ou A' en régime transitoire) destinée à être calculée à l'aide du premier programme d'ordinateur 26,
- éventuellement, une alarme 32 sonore et/ou visuelle, et
- un processeur 34, relié au port 22 pour recevoir les valeurs d'intensité effectivement transmise, à l'alarme 32 pour la déclencher sous certaines conditions définies par exemple dans le second programme 28, aux premiers moyens de stockage 24 pour l'exécution des programmes 26 et 28 et aux seconds moyens de stockage 30 pour l'utilisation des paramètres P (ou P' en régime transitoire) et pour l'enregistrement de l'ampacité A (ou A' en régime transitoire).

Le premier programme d'ordinateur 26 est plus précisément conçu pour déterminer l'ampacité A (ou A' en régime transitoire) par la sélection d'une valeur de cette ampacité par optimisation d'une probabilité de dépassement de la température de répartition Trep (ou T'rep en régime transitoire), cette probabilité étant définie sur la base des paramètres P (ou P' en régime transitoire) du modèle de probabilité stocké en mémoire 30.

On notera qu'en variante, le dispositif de surveillance 18 peut être implémenté sous la forme d'un circuit intégré non programmable. Dans ce cas, au prix d'une moindre souplesse, les calculs peuvent être accélérés.

Dans un autre mode de réalisation illustré sur la figure 3, une partie des traitements du dispositif de surveillance 18 peut être rapprochée du capteur 16 et donc implémentée dans un boîtier 36 le comportant, ce boîtier étant alors disposé le long du conducteur aérien 12. Cette partie des traitements concernée est celle portant spécifiquement sur la surveillance de la ligne à haute tension 10 lorsque son ampacité A (ou A' en régime transitoire) est connue. Elle correspond aux fonctions réalisées à l'aide du programme d'ordinateur 28 du mode de réalisation précédent.

Le boîtier 36 comporte ainsi, outre le capteur 16, une mémoire pour le stockage de l'ampacité A (ou A' en régime transitoire) de la ligne à haute tension 10, un comparateur 38 pour la détection d'un dépassement de l'ampacité A (ou A' en régime transitoire) par l'intensité mesurée par le capteur 16, et un organe 40 de déclenchement d'une action, par exemple lorsque l'intensité mesurée dépasse la valeur d'ampacité A (ou A' en régime transitoire) pendant plus d'une durée seuil prédéterminée. Cet organe 40 est par exemple une alarme sonore et/ou visuelle comme dans le mode de réalisation précédent ou, plus avantageusement dans ce mode de réalisation, un dispositif de coupure du courant transitant dans le conducteur aérien 12.

L'autre partie des traitements réalisés par le dispositif de surveillance, c'est-à-dire la partie des traitements portant sur la détermination préalable de l'ampacité A (ou A' en régime transitoire), est implémentée dans un autre appareil 42, par exemple un ordinateur ou dispositif électronique quelconque. Cet autre appareil 42 est par conséquent simplifié par rapport au dispositif électronique implémentant le dispositif de surveillance du mode de réalisation précédent : il ne comporte par exemple plus que le processeur 34, une mémoire non volatile 24 de stockage du premier programme d'ordinateur 26 et une mémoire non volatile 30 de stockage des paramètres P (ou P' en régime transitoire). Il communique avec le boîtier 36 pour la transmission d'une valeur de l'ampacité A (ou A' en régime transitoire) lorsqu'il a effectué son traitement.

D'autres modes de réalisation sont également envisageables. Par exemple, le dispositif de surveillance 18 pourrait être entièrement intégré dans le boîtier 36.

Un fonctionnement possible du dispositif de surveillance 18 va maintenant être détaillé en référence à la figure 4 pour la mise en oeuvre d'un procédé de surveillance de la ligne à haute tension 10.

Au cours d'une phase préalable 100, ce procédé consiste à déterminer, pour le régime établi, une valeur d'ampacité A de la ligne à haute tension 10 telle que la probabilité de dépasser la température de répartition Trep alors que l'intensité I transmise reste inférieure à A soit la plus proche possible, sans la dépasser, d'une valeur seuil Ps considérée comme optimale. De façon optionnelle et complémentaire, le procédé peut consister en outre à déterminer, pour le régime transitoire, une valeur d'ampacité A' de la ligne à haute tension 10 telle que la probabilité de dépasser la température de répartition T'rep alors que l'intensité I transmise reste inférieure à A' soit la plus proche possible, sans la dépasser, d'une valeur seuil P's considérée comme optimale.

La valeur seuil Ps pour le régime établi est par exemple une valeur prédéterminée fixée *a priori.* Il en est de même pour la valeur seuil P's pour le régime transitoire.

En régime établi, la probabilité de dépasser la température de répartition Trep alors que l'intensité de fonctionnement I reste inférieure à l'ampacité A est dépendante de paramètres météorologiques $\theta$ significatifs d'un environnement (lieu, saison, ...) dans lequel se trouve la ligne à haute tension 10. Elle peut avantageusement s'écrire sous la forme suivante :

$$p_{\theta}(T > Trep, I < A) = \int_0^A p_{\theta}(T > Trep, I)dI \; . \tag{1}$$

Elle est ainsi définie sur la base d'un modèle de probabilité jointe $p_{\theta}(T > Trep, I)$ de température et d'intensité de fonctionnement, cette probabilité jointe dépendant des paramètres météorologiques $\theta$ et étant intégrée sur une pluralité d'intensités comprises entre 0 et l'ampacité A. Plus précisément, et conformément aux règles d'analyse bayésienne, cette probabilité jointe $p_{\theta}(T > Trep, I)$ est le produit d'une probabilité a posteriori de température pour une intensité de fonctionnement donnée dépendant des paramètres météorologiques, notée $p_{\theta}(T > Trep|I)$, et d'une probabilité a priori d'intensité de fonctionnement dépendant des paramètres météorologiques, notée $p_{\theta}(I)$, soit :

$$p_\theta(T > Trep, I) = p_\theta(T > Trep|I)\, p_\theta(I).$$

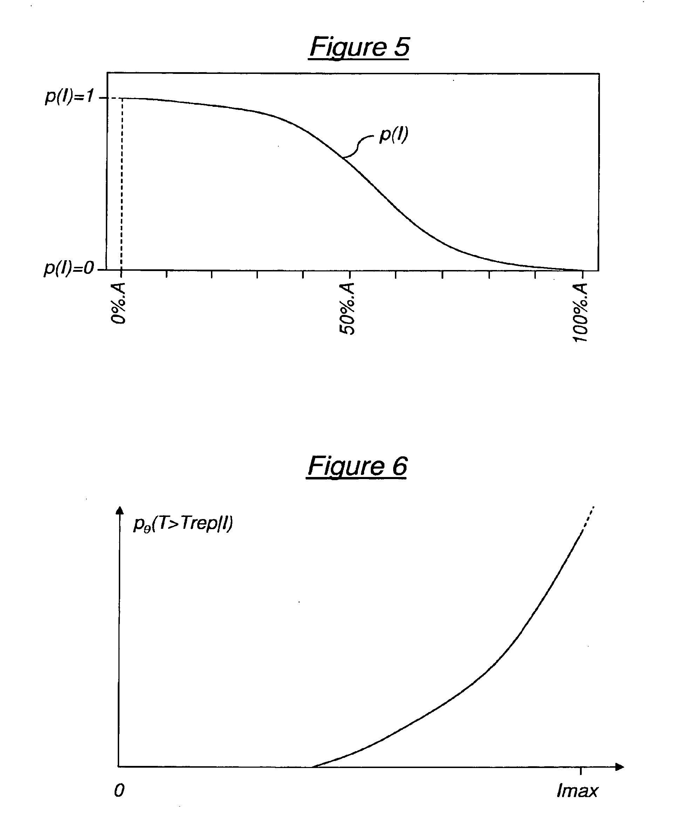

En pratique, la probabilité a priori $p_\theta(I) = p(I)$ est indépendante des paramètres météorologiques $\theta$ et de l'ampacité A. Elle suit une loi dont les paramètres peuvent être estimés sur la base d'un échantillonnage statistique d'intensités de fonctionnement de lignes à haute tension sur tout un territoire, toute une année et tous niveaux de tension confondus. Elle peut alors être représentée par une fonction de répartition représentative de la monotone de charge de la ligne à haute tension 10, telle que celle illustrée sur la figure 5, entre 0%.A et 100%.A.

Ce sont soit les paramètres statistiques (moyenne, variance, ...) d'une loi que suit cette probabilité a priori, soit directement les valeurs échantillonnées qu'elle prend, qui sont enregistrés en tant que paramètres P dans les moyens de stockage 30. Ces paramètres peuvent être prédéterminés. Ils peuvent aussi être calculés par le dispositif de surveillance 18 sur exécution du premier programme 26 au cours d'une étape 104 à partir d'un ensemble d'échantillons représentatif d'intensités de fonctionnement de lignes à haute tension sur tout un territoire, toute une année et tous niveaux de tension confondus.

En pratique également, la probabilité a posteriori $p_\theta(T>Trep|I)$ est dépendante des paramètres météorologiques $\theta$ et de l'intensité de fonctionnement I. Elle suit une loi dont les paramètres peuvent être estimés sur la base d'un échantillonnage stochastique, par exemple selon une méthode de convergence de Monte-Carlo à Chaîne de Markov (procédé d'échantillonnage MCMC, de l'anglais « Markov Chain Monte Carlo ») avec un échantillonnage numérique de Gibbs, réalisé à partir d'une fonction de transfert reliant les paramètres météorologiques $\theta$ et des paramètres de conduction de la ligne à haute tension 10, d'une part, à une température de la ligne à haute tension, d'autre part, pour une valeur d'intensité de fonctionnement donnée. Cet échantillonnage est réalisé à l'aide d'échantillons de paramètres météorologiques représentatifs de l'environnement dans lequel se trouve la ligne à haute tension 10. Chaque échantillon est par exemple un triplet de paramètres de température ambiante, ensoleillement et vitesse de vent. Ces échantillons peuvent notamment varier non seulement en fonction du lieu (un zonage peut être réalisé) mais aussi en fonction de la saison. Concrètement, sur un territoire comme la France, des études météorologiques ont été menées sur des données trihoraires de 125 stations sur une période de 20 années (1988-2007), sur la base d'un découpage du territoire en plusieurs zones géographiques homogènes vis-à-vis des distributions de température de conducteur (16 zones) et sur la base d'une définition de saisons homogènes également.

La fonction de transfert utilisée est par exemple une fonction normalisée telle que l'équation Cigré, définie dans le document intitulé « Thermal behaviour of overhead conductors », publié par le comité d'étude « B2-lignes aériennes » de l'organisation Cigré, WG 22.12, en août 2002, ou l'équation IEEE, définie dans le document intitulé « IEEE standard for calculating the current-temperature of bare overhead conductors », publié par IEEE Power Engineering Society sous la référence IEEE Std 738™-2006, en janvier 2007. Parmi les paramètres de cette fonction de transfert, seuls les paramètres météorologiques et la température de conducteur résultante sont considérés comme des variables aléatoires pour l'échantillonnage stochastique. Les paramètres de conduction de la ligne à haute tension 10 sont considérés comme constants. Par ailleurs, les paramètres géométriques intervenant éventuellement dans la fonction de transfert sont fixés par exemple à partir d'une analyse statistique de paramètres géométriques couvrant tout un réseau.

La probabilité a posteriori $p_\theta(T > Trep|I)$ peut alors être représentée par une fonction de répartition telle que celle illustrée sur la figure 6, pour I variant entre 0 et Imax ampères, Imax étant choisie pour être une valeur d'intensité de fonctionnement très défavorable compte tenu des paramètres météorologiques $\theta$, en tout cas supérieure à la valeur finale A d'ampacité recherchée.

Ce sont par exemple directement les valeurs échantillonnées qu'elle prend pour I variant entre 0 et Imax ampères qui sont enregistrés en tant que paramètres P dans les moyens de stockage 30. Ces paramètres peuvent être prédéterminés. Ils peuvent aussi être calculés par le dispositif de surveillance 18 sur exécution du premier programme 26 au cours d'une étape 106 à partir d'un ensemble d'échantillons représentatif des paramètres météorologiques $\theta$ dans l'environnement de la ligne à haute tension 10. Cette exécution ne sera pas détaillée, mais elle met en oeuvre de façon classique l'échantillonnage stochastique mentionné précédemment.

Lorsque les valeurs de Ps et des paramètres P sont connues, soit de façon prédéterminée, soit par exécution des étapes 104 et 106, on passe à une étape 108 d'initialisation, réalisée par le dispositif de surveillance 18 sur exécution du premier programme 26, lors de laquelle l'ampacité est initialisée à une première valeur Ao et un indice i est initialisé à 0. La première valeur Ao est par exemple égale à la valeur Imax, c'est-à-dire la plus grande valeur d'intensité de fonctionnement pour laquelle on dispose d'une valeur de probabilité de dépassement de la température de répartition compte tenu des paramètres météorologiques.

Ensuite, une boucle d'étapes 110, 112, 114 est exécutée au moins une fois sur au moins une valeur de l'indice i par le dispositif de surveillance 18 sur exécution du premier programme 26.

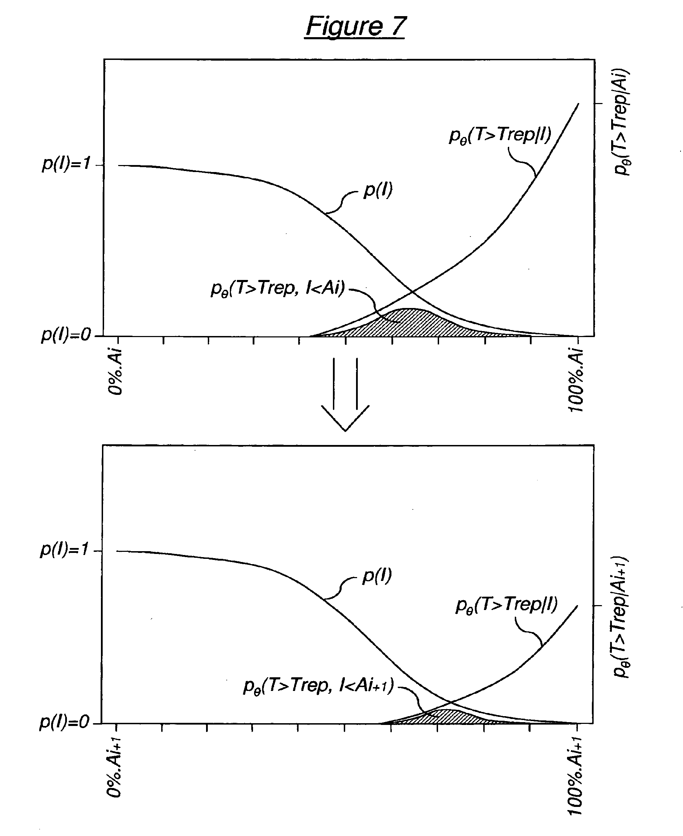

Lors de l'étape 110, la probabilité de dépassement de la température de répartition Trep pour la valeur d'ampacité Ai est calculée. Ce calcul est réalisé comme illustré sur la figure 7 (diagramme du haut). On voit sur cette figure qu'une partie de la courbe de probabilité a posteriori $p_\theta(T > Trep|I)$ de la figure 6 est reprise, entre 0 et Ai ampères, pour se caler sur la courbe de probabilité a priori $p(I)$. Ces deux courbes sont alors multipliées entre elles point à point entre 0 et Ai pour donner une courbe dont l'aire au dessus de l'axe des abscisses (en grisé sur la figure 7) donne une estimation de la valeur de la probabilité $p_\theta(T > Trep, I < Ai)$ puisque $p_\theta\left(T > Trep, I < Ai\right) = \int_0^{Ai} p_\theta\left(T > Trep|I\right)p(I)dI$ .

Lors de l'étape 112 suivante, la probabilité $p_\theta(T > Trep, I < Ai)$ est comparée à la valeur seuil Ps.

Cette étape 112 est suivie d'une étape de test 114 liée à un critère d'arrêt : par exemple un nombre maximal imax de répétitions de la boucle d'étapes 110, 112, 114 comparé à l'indice i. Ainsi, selon ce critère d'arrêt, tant que i<imax, on passe à une étape 116 de mise à jour, sinon on passe à une étape 118 d'enregistrement. En variante, le critère d'arrêt peut être le fait que la différence entre $p_\theta(T > Trep, I < Ai)$ et Ps devienne inférieure à un seuil prédéterminé $\Delta$p lorsque $p_\theta(T > Trep, I < Ai)$ est inférieure à Ps. Ainsi, selon ce critère d'arrêt, tant que $p_\theta(T > Trep, I < Ai)$ est supérieure à Ps ou que $p_\theta(T > Trep, I < Ai)$ est inférieure à Ps mais que [Ps - $p_\theta(T > Trep, I < Ai)$] > $\Delta$p, on passe à l'étape 116 de mise à jour, sinon on passe à l'étape 118 d'enregistrement.

Au cours de l'étape 116, l'indice i est incrémenté d'une unité et la valeur de Ai est mise à jour. Etant donné que l'on cherche à estimer une valeur d'ampacité A telle que la probabilité $p_\theta(T > Trep, I < A)$ soit la plus proche possible de la valeur seuil Ps sans la dépasser, la mise à jour de la valeur d'ampacité Ai consiste notamment à augmenter cette valeur si la probabilité estimée $p_\theta(T > Trep, I < Ai)$ est inférieure à Ps et à la réduire si elle est supérieure à Ps. Plus précisément, la mise à jour de la valeur d'ampacité Ai peut comporter l'application d'une convergence par dichotomie.

Suite à l'exécution de l'étape 116, le procédé reprend à l'étape 110 pour une nouvelle boucle d'étapes 110, 112, 114. Notamment le calcul de l'étape 110 reprend avec une nouvelle valeur de Ai. Le bas de la figure 7 illustre ce nouveau calcul dans le cas d'une mise à jour de Ai par réduction de sa valeur. Pour clarifier le fait que la figure 7 illustre deux exécutions successives de l'étape 110, les indices sont notés respectivement i et i+1 dans le diagramme du haut et celui du bas de la figure 7. L'étape d'enregistrement 118 exécutée en sortie de boucle consiste :

- soit à enregistrer la dernière valeur de Ai en tant qu'ampacité sélectionnée A dans les moyens de stockage 30 du dispositif de surveillance 18, dans le cas du mode de réalisation de la figure 2,
- soit à transmettre la dernière valeur de Ai en tant qu'ampacité sélectionnée A vers le boîtier 36 et à l'enregistrer dans celui-ci, dans le cas du mode de réalisation de la figure 3.

Le traitement précédemment décrit pour le régime établi et basé sur l'équation (1) s'adapte au régime transitoire. En effet, en régime transitoire, la probabilité de dépasser la température de répartition T'rep alors que l'intensité de fonctionnement I reste inférieure à l'ampacité A' peut avantageusement s'écrire sous la forme suivante :

$$\begin{aligned} p'_\theta\left(T > T'rep, I < A'\right) &= P1 \times P2 \times p_\theta\left(T > T'rep, I < A'\right) \\ &= P1 \times P2 \times \int_0^{A'} p_\theta\left(T > T'rep, I\right)dI \end{aligned} \quad, \tag{2}$$

où P1 est la probabilité d'apparition d'un défaut et P2 la probabilité d'une durée de surcharge maximale.

P1 et P2 sont des valeurs prédéterminées de pires probabilités estimées par un retour d'expérience. Le reste du calcul et du traitement se ramène au cas précédent du régime établi, sauf pour la valeur seuil Ps qui est remplacée par P's et pour l'expression de la fonction de transfert qui prend une forme transitoire. Par exemple, s'il s'agit de l'équation Cigré, c'est son expression transitoire qu'il faut retenir, cette expression nécessitant de connaître un état initial. Cet état initial est donné par la valeur d'intensité avant apparition du défaut ayant provoqué le régime transitoire, exprimée en pourcentage de l'intensité maximale pour laquelle $p_\theta(T > T'rep|I)$ reste nulle. L'étape d'enregistrement 118 porte alors sur la valeur A' trouvée.

Suite à cette étape d'enregistrement 118 mettant fin à la phase préalable 100 de détermination de l'ampacité A (ou A' en régime transitoire), le procédé illustré sur la figure 4 consiste à surveiller l'intensité du courant transitant dans la ligne à haute tension 10 au cours d'une phase de surveillance 200 proprement dite. La phase de surveillance 200 est réalisée par le dispositif de surveillance 18 sur exécution du second programme 28.

Une première étape 202 de cette phase de surveillance consiste à mesurer, à l'aide du capteur 16, une intensité courante effectivement transmise par la ligne à haute tension. Cette mesure peut être effectuée périodiquement.

Ensuite, au cours d'une étape de test 204, cette intensité mesurée est comparée à l'ampacité A enregistrée (ou A' en régime transitoire). A titre d'exemple non limitatif, si cette intensité mesurée dépasse l'ampacité A (ou A' en régime transitoire) pendant une durée supérieure à un seuil prédéterminé, l'étape de test 204 peut être suivie d'une étape finale 206 de déclenchement d'une alarme visuelle ou sonore ou de coupure de courant sur la ligne à haute tension 10.

Il apparaît clairement qu'un dispositif de surveillance tel que celui décrit précédemment selon différents modes de réalisation possibles permet de prendre en compte un facteur de risque dans l'estimation de l'ampacité de la ligne à haute tension considérée en y intégrant un modèle probabiliste. Par ailleurs, l'approche probabiliste étant plus fine et plus proche de la réalité statistique qu'une approche déterministe, l'ampacité estimée a de fortes chances d'être supérieure, ce qui permet d'augmenter la capacité de transit avec un même réseau de transport d'électricité.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

## Revendications

1.  Procédé de surveillance d'une ligne (10) de transmission de courant électrique à haute tension comportant :

    - la détermination préalable (100) d'une ampacité (A) de la ligne à haute tension (10) à partir d'une température limite de fonctionnement de la ligne à haute tension, dite température de répartition, de paramètres de conduction de la ligne à haute tension et de paramètres météorologiques,
    - la mesure (202) d'une intensité effectivement transmise par la ligne à haute tension (10) à l'aide d'au moins un capteur (16) disposé sur la ligne à haute tension, et
    - la surveillance (204), par un dispositif de surveillance (18) relié au capteur (16), d'un dépassement de l'ampacité (A) par l'intensité mesurée,

    **caractérisé en ce que** la détermination préalable (100) de l'ampacité (A) comporte :

    - la sélection (108, 110, 112, 114, 116) d'une valeur de cette ampacité (A) par optimisation d'une probabilité de dépassement de la température de répartition, cette probabilité étant définie sur la base d'un modèle de probabilité jointe de température et d'intensité de fonctionnement dépendant des paramètres météorologiques, et
    - l'enregistrement (118) de la valeur d'ampacité sélectionnée dans des moyens de stockage (30) du dispositif de surveillance (18).

2.  Procédé de surveillance d'une ligne (10) de transmission de courant électrique à haute tension selon la revendication 1, dans lequel la sélection (108, 110, 112, 114, 116) d'une valeur d'ampacité (A) comporte :

    - l'initialisation (108) de l'ampacité à une première valeur,
    - la boucle d'étapes suivantes, exécutée au moins une fois :

        • l'estimation (110) de la probabilité de dépassement de la température de répartition pour la valeur d'ampacité donnée,
        • la comparaison (112) de cette probabilité avec une valeur limite, et
        • la mise à jour (116) de la valeur d'ampacité en fonction de cette comparaison.

3.  Procédé de surveillance d'une ligne (10) de transmission de courant électrique à haute tension selon la revendication 2, dans lequel la mise à jour (116) de la valeur d'ampacité consiste à augmenter cette valeur si la probabilité estimée est inférieure à la valeur limite et à la réduire si la probabilité estimée est supérieure à la valeur limite.

4.  Procédé de surveillance d'une ligne (10) de transmission de courant électrique à haute tension selon la revendication 3, dans lequel la boucle d'étapes comporte un critère d'arrêt, notamment un nombre maximal de répétitions de la boucle d'étapes ou une différence entre la probabilité estimée et la valeur limite inférieure à un seuil prédéterminé lorsque cette probabilité estimée est inférieure à la valeur limite.

**5.** Procédé de surveillance d'une ligne (10) de transmission de courant électrique à haute tension selon l'une quelconque des revendications 2 à 4, dans lequel la mise à jour (116) de la valeur d'ampacité comporte l'application d'une convergence par dichotomie.

**6.** Procédé de surveillance d'une ligne (10) de transmission de courant électrique à haute tension selon l'une quelconque des revendications 1 à 5, dans lequel le modèle de probabilité jointe de température et d'intensité de fonctionnement est défini comme le produit, intégré sur une pluralité d'intensités comprises entre 0 et l'ampacité (A), d'une probabilité, dépendante des paramètres météorologiques, que la température de fonctionnement soit supérieure à la température de répartition pour une intensité donnée avec une probabilité que cette intensité soit atteinte compte tenu de l'ampacité (A).

**7.** Procédé de surveillance d'une ligne (10) de transmission de courant électrique à haute tension selon la revendication 6, dans lequel la probabilité, dépendante des paramètres météorologiques, que la température de fonctionnement soit supérieure à la température de répartition pour une intensité donnée est calculée sur la base d'un modèle établi par échantillonnage stochastique à partir d'échantillons de variables aléatoires météorologiques et d'une fonction de transfert prédéterminée, reliant les paramètres météorologiques et des paramètres de conduction de la ligne à haute tension à une température de fonctionnement de la ligne à haute tension.

**8.** Procédé de surveillance d'une ligne (10) de transmission de courant électrique à haute tension selon l'une quelconque des revendications 1 à 7, dans lequel, en régime transitoire de déséquilibre thermique entre les puissances d'échauffement et de refroidissement d'un conducteur aérien (12) de la ligne à haute tension, la probabilité de dépassement de la température de répartition est plus précisément définie sur la base du modèle de probabilité jointe de température et d'intensité de fonctionnement corrigé au moins par les deux facteurs multiplicatifs suivants :

- un facteur quantifiant une probabilité d'apparition d'un défaut dans la ligne à haute tension, et
- un facteur quantifiant une probabilité de durée de surcharge maximale de la ligne à haute tension.

**9.** Programme d'ordinateur téléchargeable depuis un réseau de communication et/ou enregistré sur un support lisible par ordinateur et/ou exécutable par un processeur, **caractérisé en ce qu'**il comprend des instructions pour l'exécution des étapes d'un procédé de surveillance d'une ligne (10) de transmission de courant électrique à haute tension selon l'une quelconque des revendications 1 à 8, lorsque ledit programme est exécuté sur un ordinateur.

**10.** Dispositif (18) de surveillance d'une ligne (10) de transmission de courant électrique à haute tension comportant :

- un calculateur (34, 26) conçu pour la détermination préalable d'une ampacité (A) de la ligne à haute tension (10) à partir d'une température limite de fonctionnement de la ligne à haute tension, dite température de répartition, de paramètres de conduction de la ligne à haute tension et de paramètres météorologiques,
- des moyens (30) de stockage de la valeur d'ampacité (A) déterminée,
- une interface (22) de transmission de données conçue pour la réception de données de mesure d'une intensité effectivement transmise par la ligne à haute tension (10) issues d'au moins un capteur (16) disposé sur la ligne à haute tension, et
- un détecteur (34, 28 ; 38) de dépassement de l'ampacité (A) par l'intensité mesurée,

**caractérisé en ce que** :

- les moyens de stockage (30) comportent des paramètres (P) d'un modèle de probabilité jointe de température et d'intensité de fonctionnement dépendant des paramètres météorologiques, et
- le calculateur (34, 26) est plus précisément conçu pour déterminer l'ampacité (A) de la ligne à haute tension (10) par la sélection d'une valeur de cette ampacité par optimisation d'une probabilité de dépassement de la température de répartition, cette probabilité étant définie sur la base du modèle de probabilité stocké.

**Patentansprüche**

**1.** Verfahren zur Überwachung einer Hochspannungsstromleitung (10), umfassend:

- die vorhergehende Bestimmung (100) einer Stromtragfähigkeit (A) der Hochspannungsleitung (10) ausgehend von einer Grenztemperatur für den Betrieb der Hochspannungsleitung, die Verteilungstemperatur genannt wird, von Leitungsparametern der Hochspannungsleitung und von meteorologischen Parametern,
- die Messung (202) einer effektiv durch die Hochspannungsleitung (10) übertragenen Stromstärke mittels mindestens eines Sensors (16), der auf der Hochspannungsleitung angeordnet ist, und
- die Überwachung (204) einer Überschreitung der Stromtragfähigkeit (A) durch die gemessene Stromstärke durch eine Überwachungsvorrichtung (18), die mit dem Sensor (16) verbunden ist,

**dadurch gekennzeichnet, dass** die vorhergehende Bestimmung (100) der Stromtragfähigkeit (A) umfasst:

- die Auswahl (108, 110, 112, 114, 116) eines Werts dieser Stromtragfähigkeit (A) durch Optimierung einer Wahrscheinlichkeit der Überschreitung der Verteilungstemperatur, wobei diese Wahrscheinlichkeit auf der Grundlage eines Modells der gemeinsamen Wahrscheinlichkeit der Betriebstemperatur und -stromstärke in Abhängigkeit von den meteorologischen Parametern definiert wird, und
- die Aufzeichnung (118) des ausgewählten Werts der Stromtragfähigkeit in Speichermitteln (30) der Überwachungsvorrichtung (18).

2. Verfahren zur Überwachung einer Hochspannungsstromleitung (10) nach Anspruch 1, wobei die Auswahl (108, 110, 112, 114, 116) eines Werts für die Stromtragfähigkeit (A) umfasst:

- die Initialisierung (108) der Stromtragfähigkeit auf einen ersten Wert,
- die Schleife der folgenden Schritte, die mindestens einmal ausgeführt wird:

• die Schätzung (110) der Wahrscheinlichkeit der Überschreitung der Verteilungstemperatur für den gegebenen Wert der Stromtragfähigkeite,
• der Vergleich (112) dieser Wahrscheinlichkeit mit einem Grenzwert, und
• die Aktualisierung (116) des Werts der Stromtragfähigkeit in Abhängigkeit von diesem Vergleich.

3. Verfahren zur Überwachung einer Hochspannungsstromleitung (10) nach Anspruch 2, wobei die Aktualisierung (116) des Werts der Stromtragfähigkeit darin besteht, diesen Wert zu erhöhen, wenn die geschätzte Wahrscheinlichkeit kleiner als der Grenzwert ist, und ihn zu verringern, wenn die geschätzte Wahrscheinlichkeit größer als der Grenzwert ist.

4. Verfahren zur Überwachung einer Hochspannungsstromleitung (10) nach Anspruch 3, wobei die Schleife der Schritte ein Abbruchkriterium umfasst, insbesondere eine maximale Anzahl von Wiederholungen der Schleife der Schritte oder eine Differenz zwischen der geschätzten Wahrscheinlichkeit und dem unteren Grenzwert, die kleiner als eine vorbestimmte Schwelle ist, wenn diese geschätzte Wahrscheinlichkeit kleiner als der Grenzwert ist.

5. Verfahren zur Überwachung einer Hochspannungsstromleitung (10) nach einem der Ansprüche 2 bis 4, wobei die Aktualisierung (116) des Werts der Stromtragfähigkeit die Anwendung einer Konvergenz durch Dichotomie umfasst.

6. Verfahren zur Überwachung einer Hochspannungsstromleitung (10) nach einem der Ansprüche 1 bis 5, wobei das Modell der gemeinsamen Wahrscheinlichkeit der Betriebstemperatur und -stromstärke als das über mehrere Stromstärken zwischen 0 und der Stromtragfähigkeit (A) integrierte Produkt einer von meteorologischen Parametern abhängigen Wahrscheinlichkeit, dass die Betriebstemperatur für eine gegebene Stromstärke höher ist als die Verteilungstemperatur, mit einer Wahrscheinlichkeit definiert ist, dass diese Stromstärke unter Berücksichtigung der Stromtragfähigkeit (A) erreicht wird.

7. Verfahren zur Überwachung einer Hochspannungsstromleitung (10) nach Anspruch 6, wobei die von den meteorologischen Parametern abhängige Wahrscheinlichkeit, dass die Betriebstemperatur höher ist als die Verteilungstemperatur für eine gegebene Stromstärke, auf der Grundlage eines Modells berechnet wird, das durch stochastische Abtastung ausgehend von Abtastwerten meteorologischer Zufallsvariablen und einer vorbestimmten Übertragungsfunktion aufgebaut wird, die die meteorologischen Parameter und Leitungsparameter der Hochspannungsleitung mit einer Betriebstemperatur der Hochspannungsleitung verbindet.

8. Verfahren zur Überwachung einer Hochspannungsstromleitung (10) nach einem der Ansprüche 1 bis 7, wobei im Übergangszustand des thermischen Ungleichgewichts zwischen den Erhitzungs- und Abkühlungsleistungen einer Oberleitung (12) der Hochspannungsleitung die Wahrscheinlichkeit der Überschreitung der Verteilungstemperatur genauer auf der Grundlage des Modells der gemeinsamen Wahrscheinlichkeit der Betriebstemperatur und - stromstärke definiert wird, das durch mindestens die zwei folgenden Multiplikationsfaktoren korrigiert wird:

- einen Faktor, der eine Wahrscheinlichkeit des Auftretens einer Störung in der Hochspannungsleitung quantifiziert, und
- einen Faktor, der eine Wahrscheinlichkeit der Dauer der maximalen Überlastung der Hochspannungsstromleitung quantifiziert.

**9.** Computerprogramm, das von einem Kommunikationsnetz heruntergeladen und/oder auf einem maschinenlesbaren Datenträger aufgezeichnet und/oder durch einen Prozessor ausgeführt werden kann, **dadurch gekennzeichnet, dass** es Befehle für die Ausführung der Schritte eines Verfahrens zur Überwachung einer Hochspannungsstromleitung (10) nach einem der Ansprüche 1 bis 8 umfasst, wenn das Programm auf einem Computer ausgeführt wird.

**10.** Vorrichtung (18) zur Überwachung einer Hochspannungsstromleitung (10), umfassend:

- einen Rechner (34, 26), der zur vorhergehenden Bestimmung einer Stromtragfähigkeit (A) der Hochspannungsleitung (10) ausgehend von einer Grenztemperatur für den Betrieb der Hochspannungsleitung, die Verteilungstemperatur genannt wird, von Leitungsparametern der Hochspannungsleitung und von meteorologischen Parametern ausgestaltet ist,
- Mittel (30) zur Speicherung des bestimmten Werts der Stromtragfähigkeit (A),
- eine Schnittstelle (22) zur Übertragung von Daten, die für den Empfang von Messdaten einer effektiv durch die Hochspannungsleitung (10) übertragenen Stromstärke ausgestaltet ist, die von mindestens einem Sensor (16) stammen, der auf der Hochspannungsleitung angeordnet ist, und
- einen Detektor (34, 28; 38) für die Überschreitung der Stromtragfähigkeit (A) durch die gemessene Stromstärke,

**dadurch gekennzeichnet, dass**:

- die Speicherungsmittel (30) Parameter (P) eines Modells der gemeinsamen Wahrscheinlichkeit der Betriebstemperatur und -stromstärke in Abhängigkeit von den meteorologischen Parametern umfassen, und
- der Rechner (34, 26) genauer ausgestaltet ist, die Stromtragfähigkeit (A) der Hochspannungsleitung (10) durch die Auswahl eines Werts dieser Stromtragfähigkeit durch Optimierung einer Wahrscheinlichkeit der Überschreitung der Verteilungstemperatur zu bestimmen, wobei diese Wahrscheinlichkeit auf der Grundlage des gespeicherten Wahrscheinlichkeitsmodells definiert ist.

**Claims**

**1.** Method for monitoring a high-voltage electric-current transmission line (10) comprising:

- the prior determining (100) of an ampacity (A) of the high-voltage line (10) from an operating temperature limit of the high-voltage line, referred to as distribution temperature, conduction parameters of the high-voltage line and meteorological parameters,
- the measuring (202) of a current strength effectively transmitted by the high-voltage line (10) using at least one sensor (16) arranged on the high-voltage line, and
- the monitoring (204), by a monitoring device (18) connected to the sensor (16), of an exceeding of the ampacity (A) by the current strength measured, **characterized in that** the prior determining (100) of the ampacity (A) comprises:
- the selecting (108, 110, 112, 114, 116) of a value of this ampacity (A) by optimizing a probability of exceeding the distribution temperature, with this probability defined based on a joint probability model of operating current strength and temperature that depends on meteorological parameters, and
- the recording (118) of the selected ampacity value in a storage unit (30) of the monitoring device (18).

**2.** Method for monitoring a high-voltage electric-current transmission line (10) according to claim 1, wherein the selecting (108, 110, 112, 114, 116) of an ampacity value (A) comprises:

- the initializing (108) of the ampacity to a first value,
- the loop of the following steps, executed at least one time:

- - estimating (110) the probability of exceeding the distribution temperature for the given ampacity value,
- - comparing (112) this probability with a limit value, and
- - updating (116) the ampacity value according to this comparison.

3. Method for monitoring a high-voltage electric-current transmission line (10) according to claim 2, wherein the updating (116) of the ampacity value consists in increasing this value if the estimated probability is less than the limit value and in reducing it if the estimated probability is greater than the limit value.

4. Method for monitoring a high-voltage electric-current transmission line (10) according to claim 3, wherein the loop of steps comprises a stoppage criterion, in particular a maximum number of repetitions of the loop of steps or a difference between the estimated probability and the limit value less than a predetermined threshold when this estimated probability is less than the limit value.

5. Method for monitoring a high-voltage electric-current transmission line (10) according to any of claims 2 to 4, wherein the updating (116) of the ampacity value comprises the application of a convergence by dichotomy.

6. Method for monitoring a high-voltage electric-current transmission line (10) according to any of claims 1 to 5, wherein the joint probability model of operating temperature and current strength is defined as the product, integrated over a plurality of current strengths between 0 and the ampacity (A), of a probability, depending on meteorological parameters, that the operating temperature is higher than the distribution temperature for a given current strength with a probability that this current strength is reached in light of the ampacity (A).

7. Method for monitoring a high-voltage electric-current transmission line (10) according to claim 6, wherein the probability, depending on the meteorological parameters, that the operating temperature is higher than the distribution temperature for a given current strength is calculated on the basis of a model established by stochastic sampling using samples of random meteorological variables and a predetermined transfer function, connecting the meteorological parameters and conduction parameters of the high-voltage line to an operating temperature of the high-voltage line.

8. Method for monitoring a high-voltage electric-current transmission line (10) according to any of claims 1 to 7, wherein, in a transient thermal imbalance regime between the heating and cooling powers of an overhead conductor (12) of the high-voltage line, the probability of exceeding the distribution temperature is more precisely defined on the basis of the joint probability model of operating current strength and temperature corrected at least by the following two multiplicative factors:

- a factor quantifying a probability of a defect appearing in the high-voltage line, and
- a factor quantifying a probability of the duration of maximum overload of the high-voltage line.

9. Computer program downloadable from a communication network and/or recorded on a computer readable medium and/or executable by a processor, **characterized in that** it comprises instructions for executing the steps of a method for monitoring a high-voltage electric-current transmission line (10) according to any of claims 1 to 8, when said program is executed on a computer.

10. Device (18) for monitoring a high-voltage electric-current transmission line (10) comprising:

- a computer (34, 26) designed for determining an ampacity (A) of the high-voltage line (10) from an operating temperature limit of the high-voltage line, referred to as distribution temperature, conduction parameters of the high-voltage line and meteorological parameters,
- a unit (30) for storing the determined ampacity value (A),
- a data transmission interface (22) designed to receive measurement data from a current strength effectively transmitted by the high-voltage line (10) coming from at least one sensor (16) arranged on the high-voltage line, and
- a detector (34, 28; 38) of the exceeding of the ampacity (A) by the current strength measured, **characterized in that**:
- the storage unit (30) comprises parameters (P) of a joint probability model of operating current strength and temperature that depends on meteorological parameters, and
- the computer (34, 26) is more precisely designed to determine the ampacity (A) of the high-voltage line (10) by selecting a value of this ampacity by optimizing a probability of exceeding the distribution temperature, with this probability defined based on the stored probability model.

## Figure 1

## Figure 2

## Figure 3

## Figure 4

## Figure 5

## Figure 6

## Figure 7

## RÉFÉRENCES CITÉES DANS LA DESCRIPTION

**Documents brevets cités dans la description**

- WO 2010054072 A

- US 20100017153 A1

**Littérature non-brevet citée dans la description**

- Thermal behaviour of overhead conductors. *B2-lignes aériennes,* Août 2002

- IEEE standard for calculating the current-temperature of bare overhead conductors. *IEEE Power Engineering Society sous la référence IEEE Std 738™-2006,* Janvier 2007